# EUROPEAN PATENT APPLICATION

(11) **EP 4 123 381 A1**
(43) Date of publication of application: **25.01.2023**
(21) Application number: 22153367.2
(22) Date of filing: 26.01.2022
(51) Int. Cl.: G03F 7/20, G02B 7/182, F16B 11/00

(54) **METHOD AND DEVICE FOR PRODUCING AN ADHESIVE BOND BETWEEN A FIRST COMPONENT AND AT LEAST ONE SECOND COMPONENT FOR MICROLITHOGRAPHY**

(71) Applicant: Carl Zeiss SMT GmbH, 73447 Oberkochen (DE)
(72) Inventor: Bader, Dieter, 73571 Goeggingen (DE); Ostendorf, Alexander, 89129 Langenau (DE)
(74) Representative: Carl Zeiss SMT GmbH

(57) **Abstract**

The invention relates to a method and a device for producing an adhesive bond between a first component and at least one second component for microlithography. A method comprises the following steps: Temporarily fixing a holding device (130, 330) onto the second component (120, 320, 420), wherein said holding device makes it possible to hold the second component against gravity in a distance above a basis, said distance being adjustable using an adjustment unit (140, 340); applying a defined amount of adhesive (150, 350, 450) onto the second component and/or the first component (110, 310, 410); bringing said second component (120, 320, 420) into a starting position above the first component (110, 310, 410) so that the second component (120, 320, 420) is held by said holding device (130, 330) against gravity; and lowering the second component (120, 320, 420) using the adjustment unit (140, 340), thereby successively increasing a contact surface between the adhesive (150, 350a, 350b, 450) and the first component (110, 310, 410).

## Description

### BACKGROUND OF THE INVENTION

### Field of the invention

The invention relates to a method and a device for producing an adhesive bond between a first component and at least one second component for microlithography. The invention can serve in particular for producing an adhesive bond between an optical element such as e.g. a mirror for microlithography as first component and any arbitrary element such as a mounting part, a polarizer, a retroreflector, an optical grid etc. as second component. The invention furthermore relates to a method for producing a microlithographic projection exposure apparatus comprising an illumination device and a projection lens, wherein an adhesive bond between a first component and at least one second component is produced in the illumination device and/or in the projection lens.

### Prior art

Microlithography is used for producing microstructured components such as, for example, integrated circuits or LCDs. The microlithography process is conducted in what is called a projection exposure apparatus, which comprises an illumination device and a projection lens. The image of a mask (= reticle) illuminated by means of the illumination device is projected here by means of the projection lens onto a substrate (e.g. a silicon wafer) coated with a light-sensitive layer (= photoresist) and disposed in the image plane of the projection lens, in order to transfer the mask structure to the light-sensitive coating of the substrate.

In projection lenses designed for the EUV range, i.e., at wavelengths of, e.g., approximately 13 nm or approximately 7 nm, mirrors are used as optical components for the imaging process owing to the lack of availability of suitable light-transmissive refractive materials.

Both in systems designed for the EUV range and in DUV systems (i.e. at wavelengths of less than 250 nm, in particular less than 200 nm), there is a need to fix onto one or more of the optical elements, for different reasons or use cases, certain components by means of adhesive bonds.

In the case of such adhesive bonds, a precise setting of the adhesive gap, which is desirable or necessary both for reasons of the service life of the adhesive bond and in order to avoid undesired optical aberrations in the optical system, constitutes a demanding challenge due to the high accuracy requirements in lithography applications. This is owing to the fact, inter alia, that the defined setting of the respective adhesive gap at the generally curved joining surfaces is made more difficult by diverse factors including, in particular, manufacturing-dictated geometry deviations of the joining surfaces, viscosity fluctuations of the adhesive and gravitation influences on, inter alia, the flow behaviour of the adhesive and the exact orientation of the components. An additional factor is that, in view of the high accuracy requirements, the introduction of mechanical stresses and deformations associated therewith in particular into the respective optical element must be reliably prevented.

### SUMMARY OF THE INVENTION

It is an object of the present invention to provide a method and a device for producing an adhesive bond between a first component and at least one second component for microlithography which enable a reliable and precise setting of the adhesive gap while at least partly avoiding the problems described above.

This object is achieved by means of the method in accordance with the features of independent Claim 1 and respectively the device in accordance with the features of Claim 15.

A method according to the invention for producing an adhesive bond between a first component and at least one second component for microlithography comprises the following steps:
- temporarily fixing a holding device onto the second component, wherein said holding device makes it possible to hold the second component against gravity in a distance above a basis, said distance being adjustable using an adjustment unit;
- applying a defined amount of adhesive onto the second component and/or the first component;
- bringing said second component into a starting position above the first component so that the second component is held by said holding device against gravity; and
- lowering the second component using the adjustment unit, thereby successively increasing a contact surface between the adhesive and the first component.

The invention is advantageously able to be realized in all applications for microlithography which strive to achieve as reliable and precise setting of an adhesive gap as possible while at least partly avoiding the problems described in the introduction.

In the context of the requirements for microlithography the present invention is based on the concept, in particular, when producing an adhesive bond, of realizing the precise and controlled setting of an adhesive gap between a first component (such as a lens element or a mirror) and a second component (such as e.g. a plate, a mounting part, a polarizer, a retroreflector, an actuator unit or an optical grid) by making use of a holding device temporarily fixed onto the second component, said second component and/or said first component being provided with a defined amount of adhesive, and an adjustment unit in order to bring the adhesive into contact with the first component with a successively increasing contact surface.

In accordance with one embodiment, said step of lowering the second component is performed until a full-surface adhesive bond is achieved.

In accordance with one embodiment, said adjustment unit abuts against an upper surface of the first component during said step of bringing said second component into a starting position and during said step of lowering the second component.

In accordance with one embodiment said adjustment unit comprises at least one adjustment screw, in particular three adjustment screws, to generate a three-point support or mounting (thereby also avoiding an over-determination of the mounting).

In accordance with one embodiment said defined amount of adhesive being applied onto the second component and/or the first component is calculated in advance in dependence on a desired final adhesive gap to be achieved.

In accordance with one embodiment, said step of lowering the second component is monitored using a monitoring arrangement.

In accordance with one embodiment, said monitoring comprises a visual inspection through said first component.

In accordance with one embodiment, said monitoring arrangement comprises an illumination device.

In accordance with one embodiment, said monitoring arrangement comprises a camera.

In accordance with one embodiment, said method further comprises, before lowering the second component using the adjustment unit, the step of aligning the lateral position of the second component. Said step of aligning the lateral position of the second component can in particular be performed using at least one lateral end stop. In particular three end stops can be used in order define the position of the second component in the degrees of freedom "dx" (i.e. translational displacement along the x-axis), "dy" (i.e. translational displacement along the y-axis) and "Rz" (i.e. rotation around the z-axis). Furthermore, other appropriate technologies, e.g. optical technologies such as confocal sensors, for aligning the lateral position of the second component are also possible.

In accordance with one embodiment, the method further comprises the step of temporarily applying, onto the first component, a protective foil to achieve a region-wise protection of the first component against adhesive.

Such a protective foil is particularly advantageous if the first component has a curved (e.g. spherical) surface, since in such a scenario gravitation has a relatively strong effect on the adhesive such that said adhesive may be extracted out of the gap between first and second component and may reach other regions of the surface of the first component (where it may give rise to undesired mechanical tensions during the lifetime of the optical system). Furthermore, extraction of the adhesive out of the gap between first and second component may also be due to capillary action and/or due to wetting properties of the surface of the first component, in particular if said wetting is enlarged e.g. due to the presence of coatings or if said wetting is inhomogeneous e.g. due to surface roughness.

In accordance with one embodiment, the first component is an optical element, in particular a mirror or a lens element.

In accordance with one embodiment, the second component is a mounting part, a polarizer, a retroreflector, an actuator unit or an optical grid. Further, more than one second components can be fixed onto the first component using the present invention.

The invention furthermore also relates to a method for producing a microlithographic projection exposure apparatus comprising an illumination device and a projection lens, wherein an adhesive bond between a first component and a second component in the illumination device and/or in the projection lens is produced by carrying out a method having the features described above.

The invention furthermore also relates to a device for producing an adhesive bond between a first component and at least one second component for microlithography, wherein the device is configured for carrying out a method having the features described above.

Further configurations of the invention can be gathered from the description and the dependent claims.

The invention is explained in greater detail below on the basis of exemplary embodiments illustrated in the accompanying figures.

### BRIEF DESCRIPTION OF THE DRAWINGS

In the figures:
- Figures 1a-1g: show schematic illustrations for elucidating the possible sequence of a method according to the invention;
- Figure 2: shows a flow diagram for elucidating a sequence of the method according to the invention in one exemplary embodiment;
- Figures 3a-3d: show schematic illustrations for elucidating exemplary configurations of a component that is bonded to an optical element using a method according to the invention;
- Figure 4: shows a schematic illustration for elucidating a further possible embodiment of the invention;
- Figure 5: shows a schematic illustration for elucidating the possible construction of a microlithographic projection exposure apparatus designed for operation in the EUV; and
- Figure 6: shows a schematic illustration for elucidating the possible construction of a microlithographic projection exposure apparatus designed for operation in the DUV range.

### DETAILED DESCRIPTION OF PREFERRED EMBODIMENTS

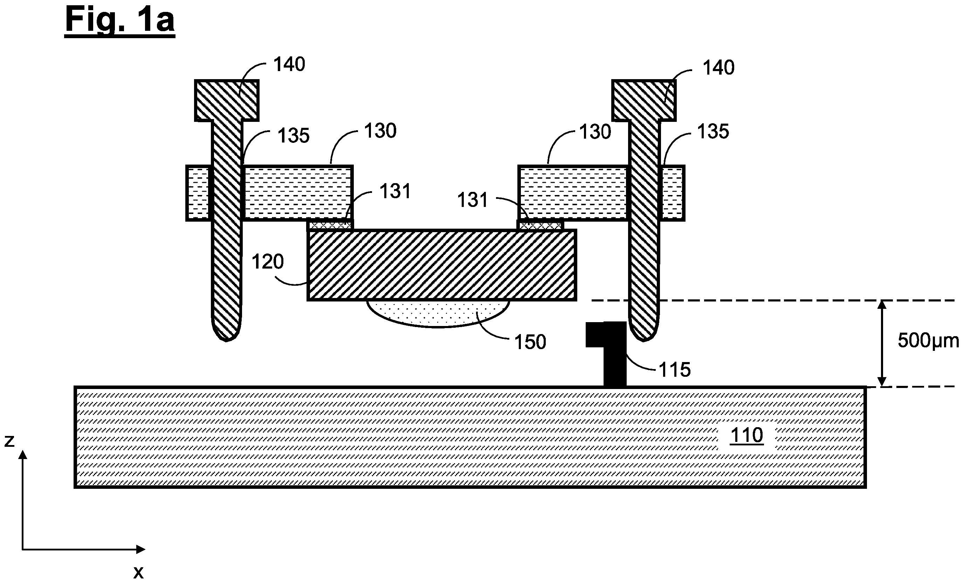

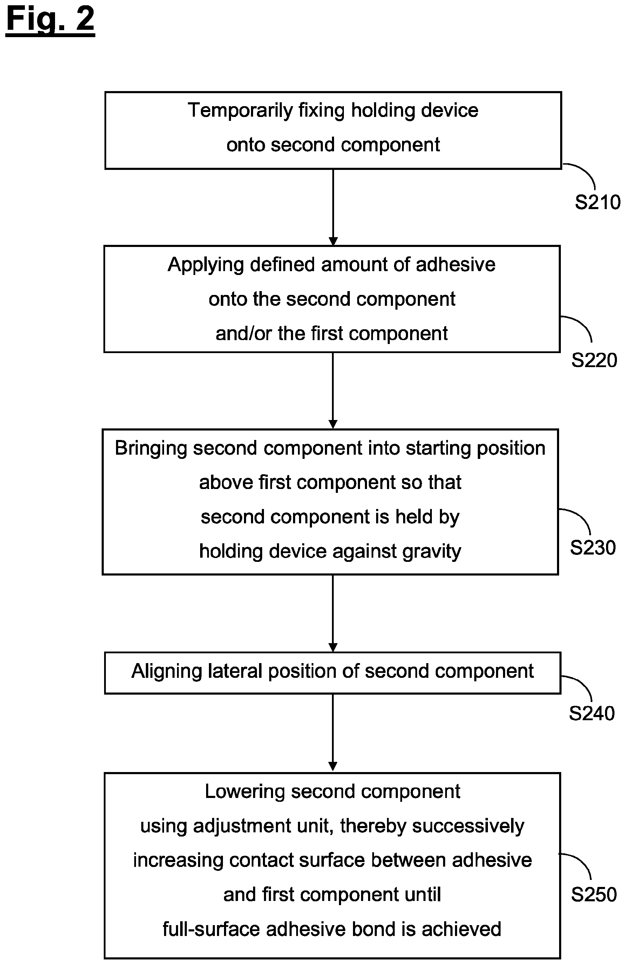

Embodiments of the method according to the invention are explained below with reference to the schematic depictions in Fig. 1a-1g and the flow diagram shown in Fig. 2.

In the preferred embodiment which is described in the following with reference to Fig. 1a-1g and Fig. 2, the inventive method is realized in order to produce a reliable and precise adhesive bond between an optical element (in particular a mirror) as first component 110 and a second component 120 (which in the exemplarily embodiment is a mounting part). According to Fig. 1a, a holding device 130 is temporarily fixed onto the second component 120 or mounting part, respectively, (see step S210 according to Fig. 2), said holding device 130 serving to hold the second component 120 or mounting part, respectively, against gravity in an adjustable distance above the first component 110 or optical element, respectively.

It is to be noted that any appropriate fixing technology can be used in order to temporarily fix the holding device 130 onto the second component 120, such as vacuum cups, bayonet joint, dovetail joint, screw connection or the like, wherein a respective fixing element realizing said joint is just schematically shown and designated as "131".

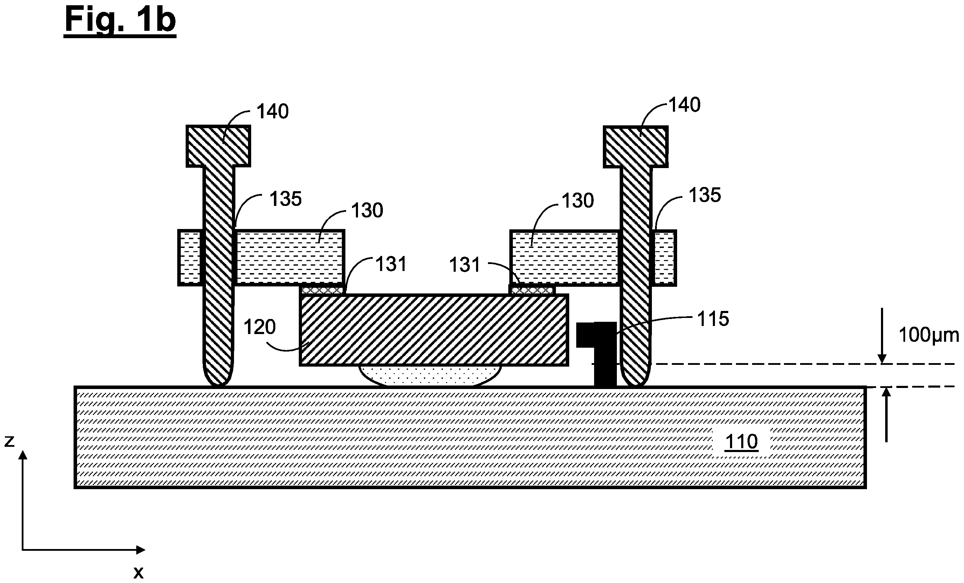

In order to enable a fine adjustment of the holding device 130 and the second component 120 fixed thereto with respect to the first component 110, at least one adjustment unit 140 is used. This adjustment unit 140 is exemplarily embodied as an adjustment screw and situated within a threaded hole 135 within the holding device 130 such that it abuts - as shown in Fig. 1b - against an upper surface of the first component 110, thereby enabling to lower the whole arrangement of holding device 130 and second component 120 by an adjustable amount by turning the adjustment screw.

A defined amount of adhesive 150 is applied in step S220 according to Fig. 2 onto the second component 120 and/or the first component 110. The step of applying the adhesive 150 can be made in any appropriate stage of the procedure, e.g. in an inversed position of the second component 120 and making use of a flipping process. In addition, or as alternative, the adhesive 150 can also be applied directly onto the first component 110, so that the adhesive 150 will become in contact with the second component 120 during approaching.

Said defined amount of adhesive 150 is calculated in advance in dependence on a desired final adhesive gap to be achieved at the end of the process. In an exemplarily embodiment, a volume of 20 mm² * 0.05 mm = 1 mm³ of adhesive 150 can be used in order to create an adhesive gap of 50 µm for a surface of second component 120 of 20 mm². For a typical specific weight of the adhesive of 1.4 kg per litre this yields a mass of 14 mg adhesive. In further embodiments, the afore-mentioned values can be adapted in order to create adhesive gaps having different values e.g. between 10 µm and 200 µm depending on properties of the adhesive (such as filling materials, viscosity or pot life) as well as depending on surface condition and cleaning condition of the components to be joined.

After the defined amount of adhesive 150 has been applied onto the second component 120, as shown in Fig. 1b, the second component 120 or mounting part, respectively, is brought into a starting position above the first component 110 or optical element, respectively such that the adjustment unit 140 abuts against the upper surface of the first component 110 (see Fig. 1b).

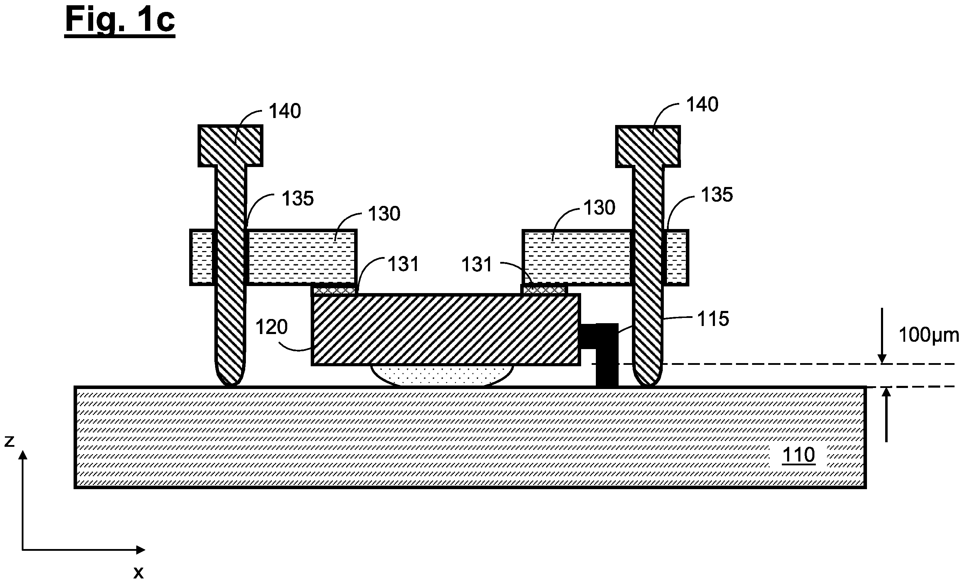

As can also be seen in Fig. 1b, the gap between the lower surface of the second component 120 and the upper surface of the first component 110, in which gap the adhesive 150 is situated, is still relatively large at this stage of the procedure (and may e.g. amount to 100 µm). An alignment of the lateral position of the second component 120 is preferably performed in this stage of the procedure in step S240 and as shown in Fig. 1c making use of at least one lateral end stop 115 (defining the position of the second component 120 in x-y-plane). This lateral alignment step can also be monitored using appropriate sensors such as contactless confocal sensors.

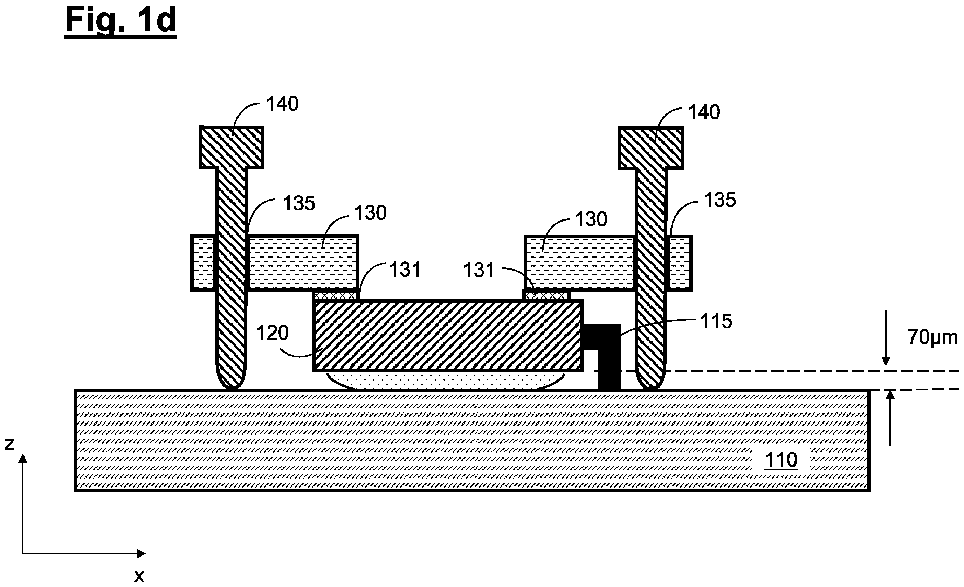

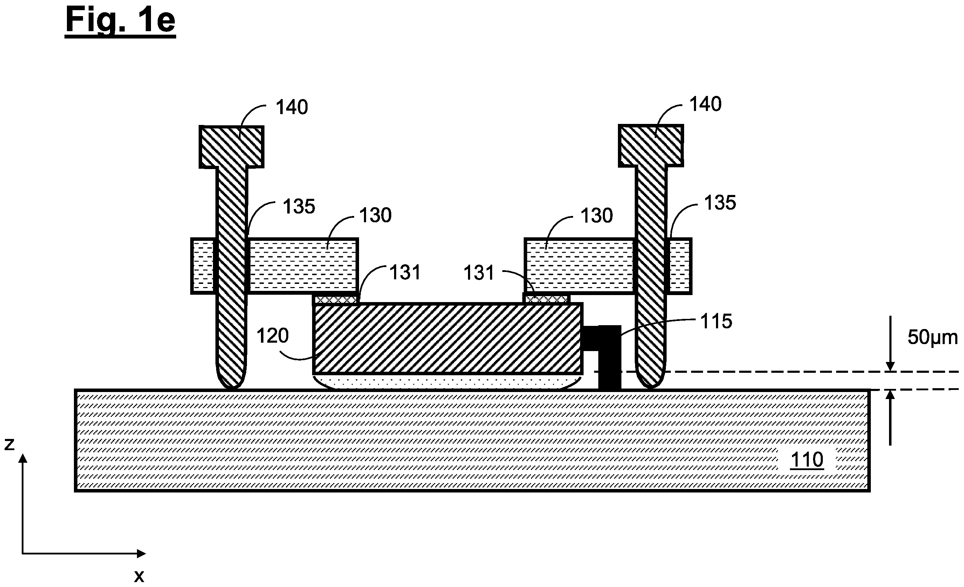

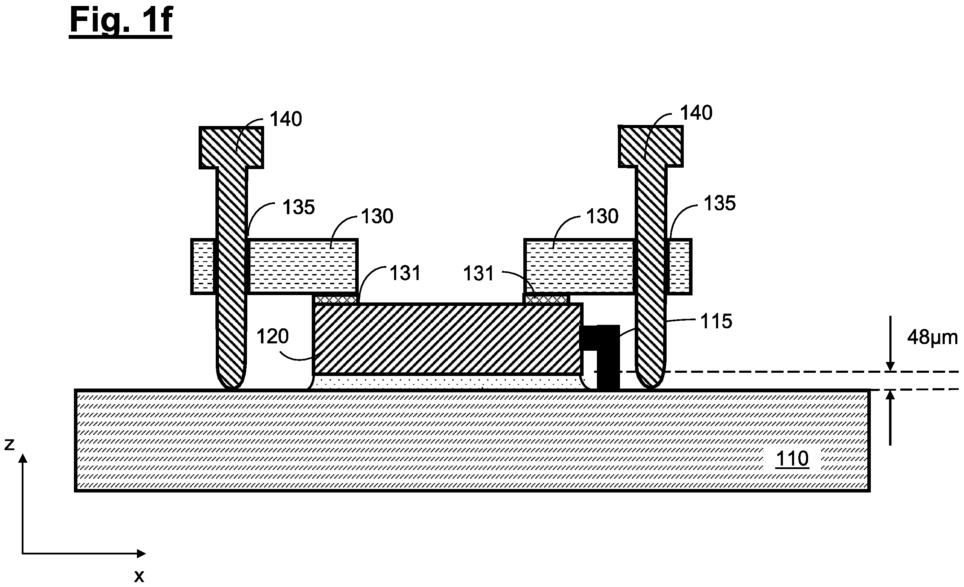

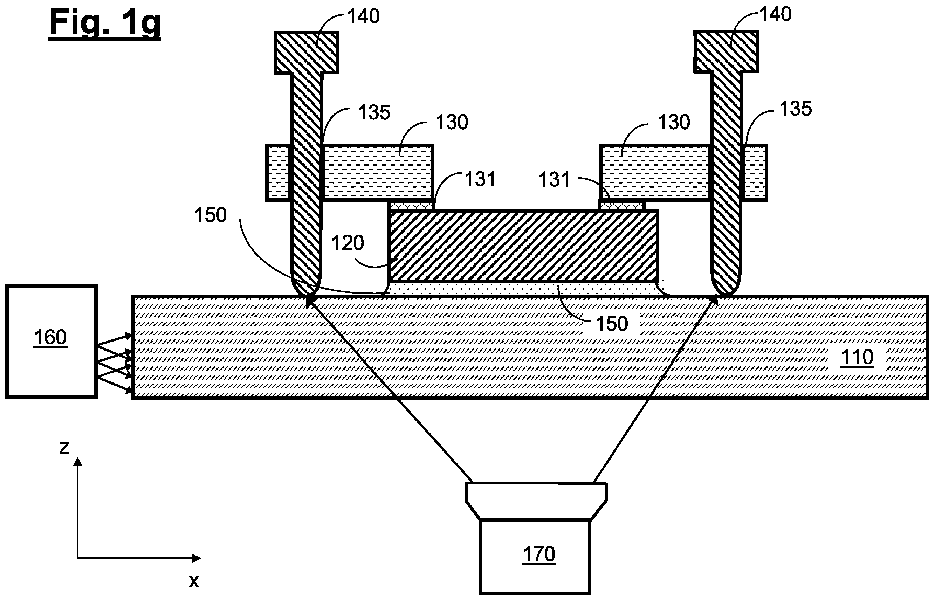

Afterwards (and as illustrated in Fig. 1d, 1e and 1f) the second component 120 is successively lowered in step S250 using the adjustment unit 140, thereby successively increasing the contact surface between adhesive 150 and first component 110. This process of lowering the second component 120 is preferably being monitored according to Fig. 1g using a monitoring arrangement that comprises an illumination device 160 and a camera 170. Here, the inventive method can exploit, if given, a transparency of the optical element (e.g. a mirror substrate in its uncoated state or a lens) sufficient to enable a visual inspection from the adhesive bond from the side of the first component 110 facing away from the adhesive 150 or holding device 130, respectively. If transparency of the optical element (e.g. mirror substrate) is not sufficient, a monitoring or inspection of the adhesive bond and meniscus can be realized from above (i.e. from the side facing the holding device 130) using a camera or the like.

Furthermore, said monitoring makes it possible to precisely stop the lowering of the second component 120 as soon as a full-surface adhesive bond is achieved between first and second component 110, 120. As shown in Fig. 1f and 1g, an extremely small meniscus is formed while any unwanted defects in the adhesive bond can be minimized. Furthermore, a clean surface of the first component 110 being free from adhesive in the region outside the adhesive bond is achieved.

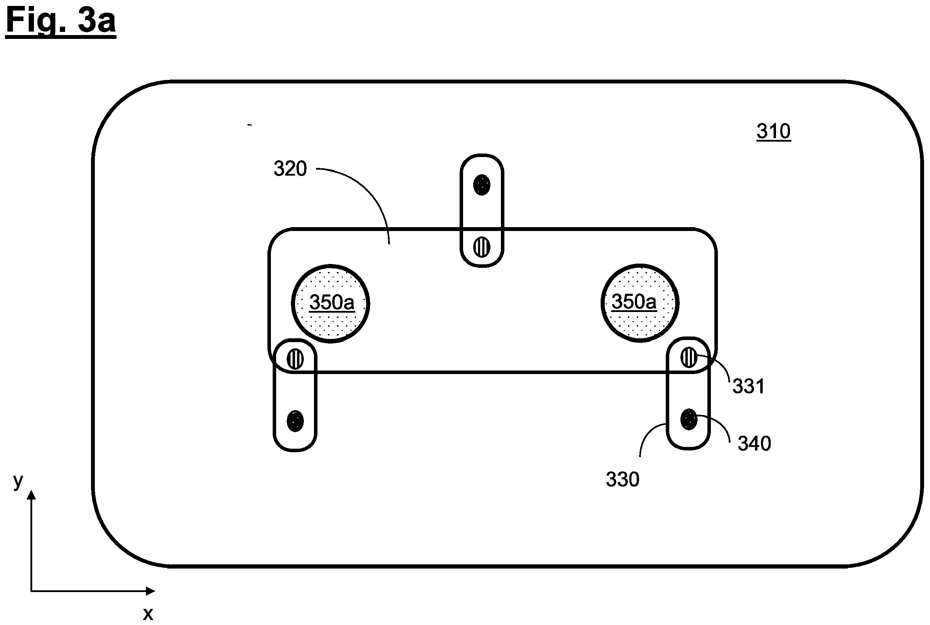

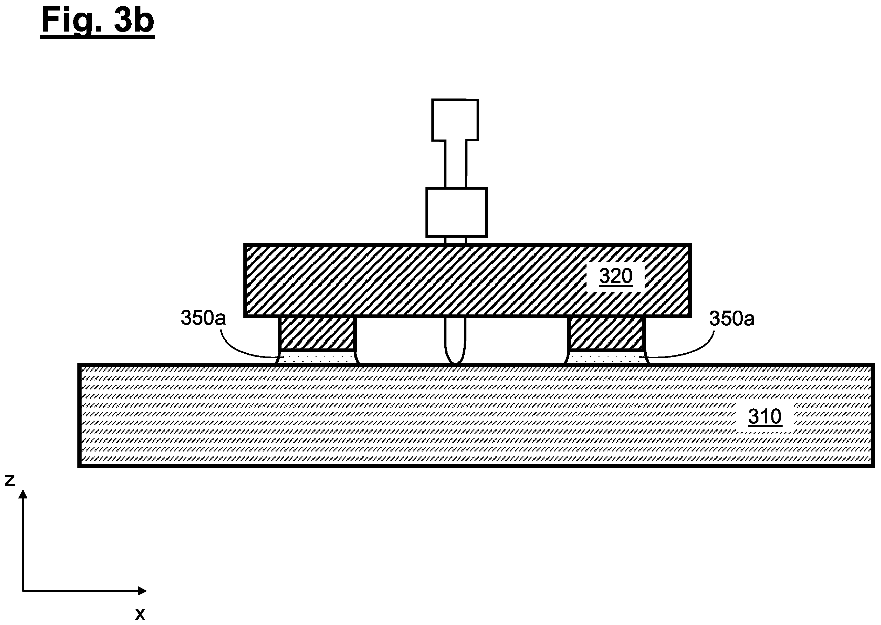

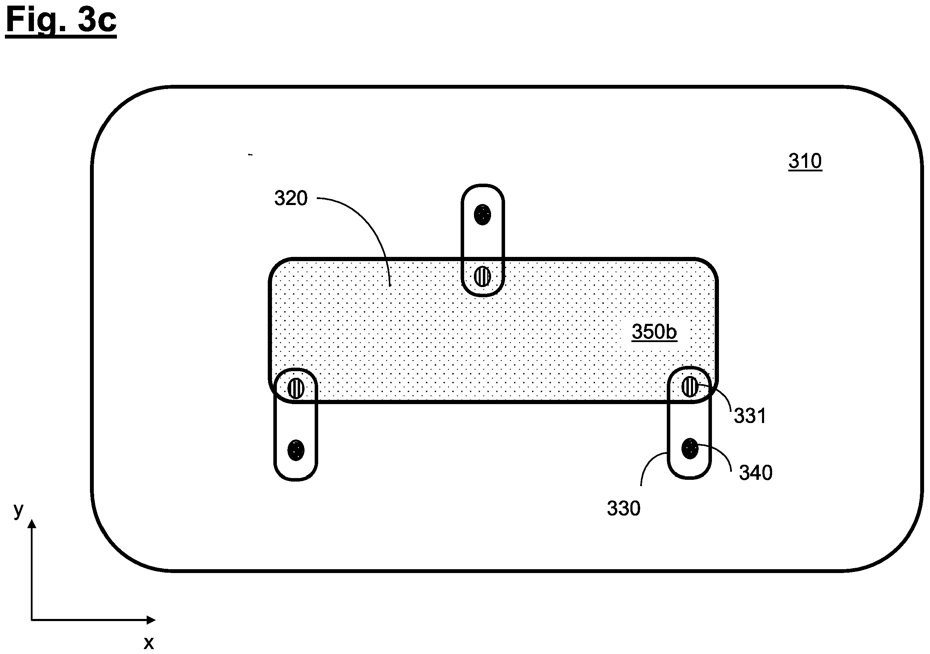

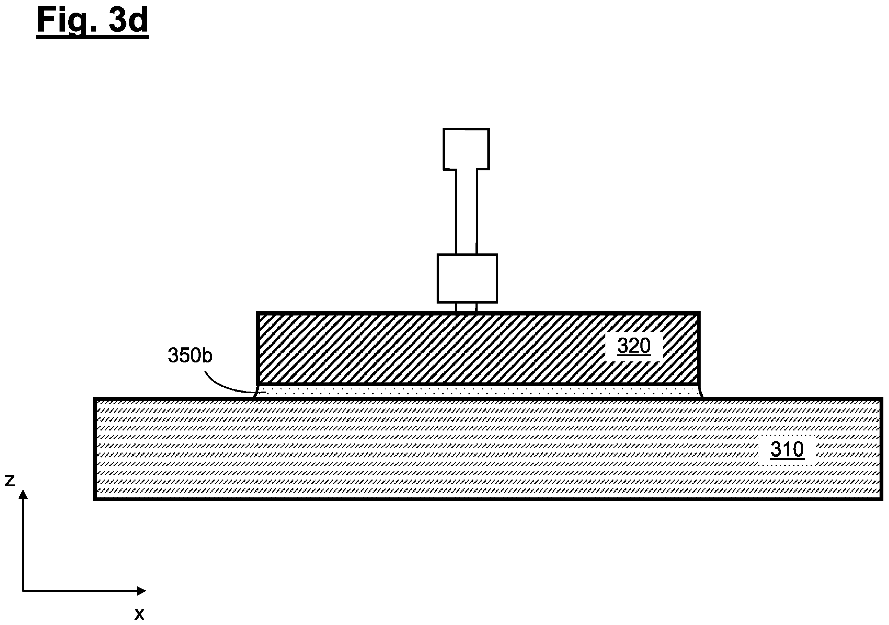

The invention can be applied to fix any second component such as a mounting part for example - but without being restricted thereto - to the rear side of an optical element (i.e. the side facing away from the optical effective surface) by means of adhesive bonds. Fig. 3a-3b and Fig. 3c-3d only schematically show possible appropriate configurations. Components which are analogous to the embodiment of Fig. 1a-1g or which have essentially the same functionality are designated with reference signs larger by "200". According to Fig. 3a (showing a schematical plan view) and Fig. 3b (showing a schematical cross-sectional view), two adhesive regions 310a are provided on respective protruding portions of the second component 320 or mounting part, respectively. A full-faced adhesive region 310b is realized in the embodiment of Fig. 3c (showing a schematical plan view) and Fig. 3d (showing a schematical cross-sectional view).

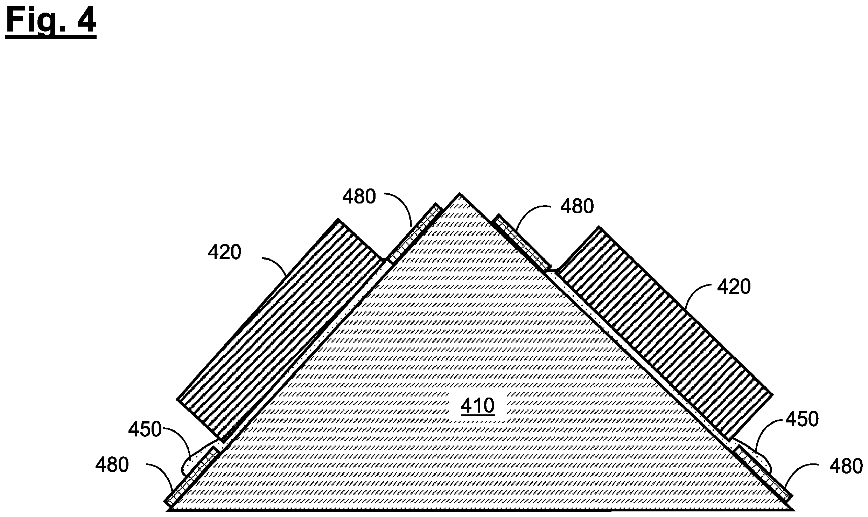

Fig. 4 shows a schematic illustration for elucidating a further possible embodiment of the invention, wherein analogous components compared with Fig. 1a-1g are designated with designation numbers larger by "300". According to Fig. 4, a protective foil 480 is used in order to achieve a region-wise protection of the first component 410 against adhesive 450. The first component 410 has a prism-shape with inclined surfaces increasing the risk that adhesive 450 may be partially extracted out of the gap between the first component 410 and the second component 420 (here in the form of two plates) and may reach other regions of the surface of the first component 410. Extraction of the adhesive 450 out of the gap between first and second component 410, 420 may also be due to capillary action and/or due to the wetting properties of the surface of the first component 410. The afore-described features make it particularly advantageous to temporarily apply the protection foil 480 to achieve a region-wise protection of the first component 410 against adhesive 450.

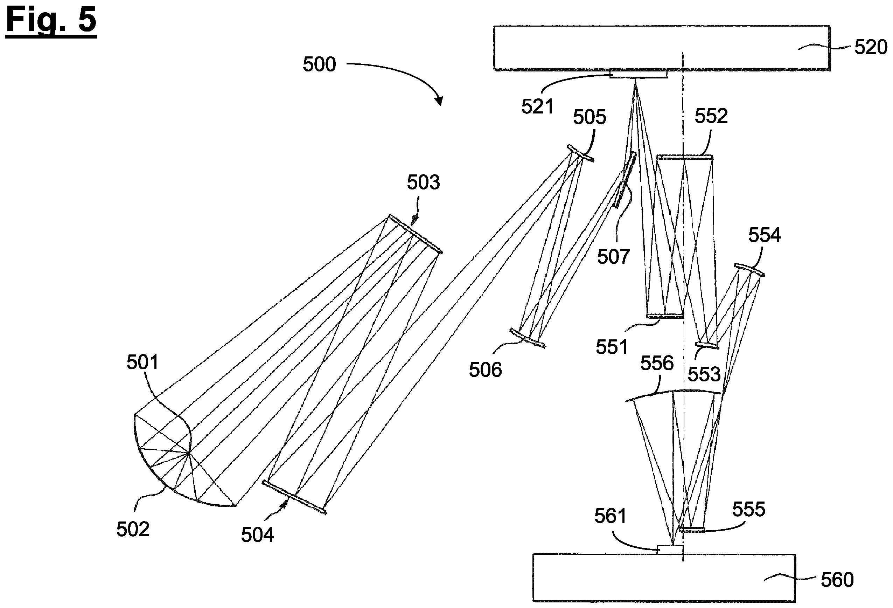

Fig. 5 shows a schematic illustration of an exemplary projection exposure apparatus which is designed for operation in the EUV and in which the present invention can be realized.

According to Fig. 5, an illumination device in a projection exposure apparatus 500 designed for EUV comprises a field facet mirror 503 and a pupil facet mirror 504. The light from a light source unit comprising a plasma light source 501 and a collector mirror 502 is directed onto the field facet mirror 503. A first telescope mirror 505 and a second telescope mirror 506 are arranged in the light path downstream of the pupil facet mirror 504. A deflection mirror 507 is arranged downstream in the light path, said deflection mirror directing the radiation that is incident thereon onto an object field in the object plane of a projection lens comprising six mirrors 551-556. At the location of the object field, a reflective structure-bearing mask 521 is arranged on a mask stage 520, said mask being imaged with the aid of the projection lens into an image plane in which a substrate 561 coated with a light-sensitive layer (photoresist) is situated on a wafer stage 560.

In further applications, the invention can also be realized in a projection exposure apparatus designed for operation in the DUV.

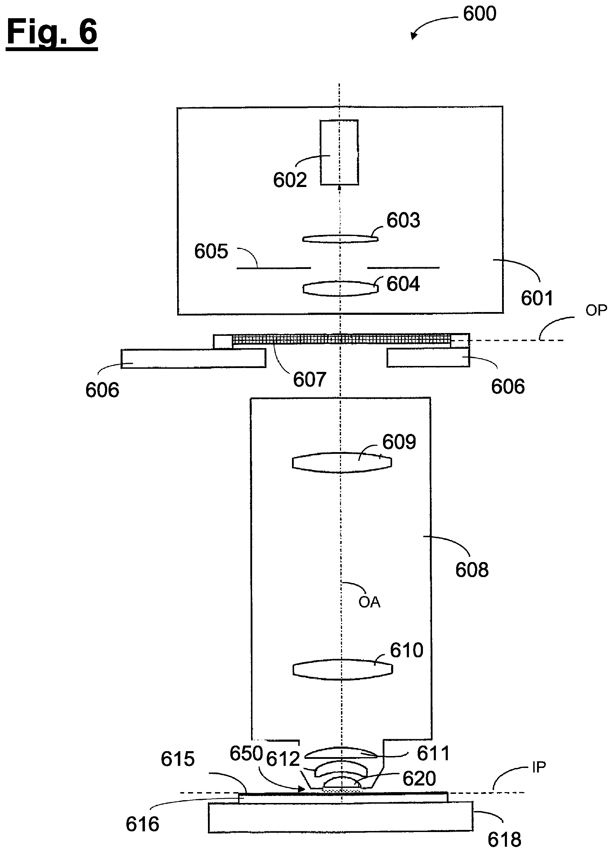

Fig. 6 shows a schematic illustration of a further possible construction of a microlithographic projection exposure apparatus 600 which is designed for operation at wavelengths in the DUV range (for example approximately 193 nm) and likewise comprises an illumination device 601 and a projection lens 608.

The illumination device 601 comprises a light source 602 and an illumination optical unit symbolized in highly simplified fashion by lens elements 603, 604 and a stop 605. The operating wavelength of the projection exposure apparatus 600 in the example shown is 193 nm when using an ArF excimer laser as the light source 602. However, the operating wavelength can for example also be 248 nm when using a KrF excimer laser or 157 nm when using an F₂ laser as the light source 602. Between the illumination device 601 and the projection lens 608, a mask 607 is arranged in the object plane OP of the projection lens 608, said mask being held in the beam path by means of a mask holder 606. The mask 607 has a structure in the micrometre to nanometre range that is imaged, for example reduced by a factor 4 or 5, onto an image plane IP of the projection lens 608 by means of the projection lens 608. The projection lens 608 comprises a lens element arrangement by way of which an optical axis OA is defined, said lens arrangement likewise merely being symbolized in highly simplified fashion by lens elements 609 to 612.

A substrate 616, or a wafer, that has been provided with a light-sensitive layer 615 and positioned by way of a substrate holder 618 is held in the image plane IP of the projection lens 608. An immersion medium 650, which may be for example deionized water, is situated between the optical element 620 of the projection lens 608 that is located last on the image plane side and the light-sensitive layer 615.

## Claims

1. Method for producing an adhesive bond between a first component and at least one second component for microlithography, wherein the method comprises the following steps:
a) temporarily fixing a holding device (130, 330) onto the at least one second component (120, 320, 420), wherein said holding device (130, 330) makes it possible to hold the second component (120, 320, 420) against gravity in a distance above a basis, said distance being adjustable using an adjustment unit (140, 340);
b) applying a defined amount of adhesive (150, 350a, 350b, 450) onto the second component (120, 320, 420) and/or the first component (110, 310, 410);
c) bringing said second component (120, 320, 420) into a starting position above the first component (110, 310, 410) so that the second component (120, 320, 420) is held by said holding device (130, 330) against gravity; and
d) lowering the second component (120, 320, 420) using the adjustment unit (140, 340), thereby successively increasing a contact surface between the adhesive (150, 350a, 350b, 450) and the first component (110, 310, 410).

2. Method according to Claim 1, **characterized in that** lowering the second component (120, 320, 420) is performed in said step d) until a full-surface adhesive bond is achieved.

3. Method according to Claim 1 or 2, **characterized in that** said adjustment unit (140, 340) abuts against an upper surface of the first component (110, 310, 410) during said steps c) and d).

4. Method according to anyone of the Claims 1 to 3, **characterized in that** said adjustment unit (140, 340) comprises at least one adjustment screw, in particular three adjustment screws.

5. Method according to anyone of the preceding Claims, **characterized in that** said defined amount of adhesive (150, 450) being applied in step b) is calculated in advance in dependence on a desired final adhesive gap to be achieved.

6. Method according to anyone of the preceding Claims, **characterized in that** step d) of lowering the second component (120, 420) is monitored using a monitoring arrangement.

7. Method according to Claim 6, **characterized in that** said monitoring comprises a visual inspection through the first component (110, 410).

8. Method according to Claim 6 or 7, **characterized in that** said monitoring arrangement comprises an illumination device (160) and/or a camera (170).

9. Method according to any of the preceding claims, **characterized in that** it further comprises, before step d), the step of aligning the lateral position of the second component (120, 420).

10. Method according to Claim 9, **characterized in that** the step of aligning the lateral position of the second component (120, 420) is performed using at least one lateral end stop (115).

11. Method according to any of the preceding claims, **characterized in that** it further comprises the step of temporarily applying, onto the first component (110, 410), a protective foil (480) to achieve a region-wise protection of the first component (110, 410) against adhesive (150, 450).

12. Method according to any of the preceding claims, **characterized in that** the first component (110, 410) is an optical element, in particular a mirror or a lens element.

13. Method according to any of the preceding claims, **characterized in that** the second component (120, 420) belongs to the group consisting of a mounting part, a polarizer, a retroreflector, an actuator unit and an optical grid.

14. Method for producing a microlithographic projection exposure apparatus (500, 600) comprising an illumination device and a projection lens, wherein an adhesive bond between a first component and at least one second component in the illumination device and/or in the projection lens is produced by carrying out a method according to any of Claims 1 to 13.

15. Device for producing an adhesive bond between a first component and at least one second component for microlithography, **characterized in that** said device is configured for carrying out a method according to any of Claims 1 to 13.
